Europäisches Patentamt

European Patent Office

Office européen des brevets

(11) Veröffentlichungsnummer: **0 226 021**
**A1**

(12) **EUROPÄISCHE PATENTANMELDUNG**

(21) Anmeldenummer: **86115303.9**

(22) Anmeldetag: **05.11.86**

(51) Int. Cl.4: **H01L 29/743** , H01L 29/08

(30) Priorität: **12.12.85 CH 5305/85**

(43) Veröffentlichungstag der Anmeldung:
**24.06.87 Patentblatt 87/26**

(84) Benannte Vertragsstaaten:
**CH DE FR GB IT LI NL SE**

(71) Anmelder: **BBC Aktiengesellschaft Brown,
Boveri & Cie.
Haselstrasse
CH-5401 Baden(CH)**

(72) Erfinder: **Roggwiller, Peter, Dr.
Püntstrasse 16
CH-8173 Riedt(CH)**

(54) **Thyristor mit schaltbarem Emitter-Kurzschluss.**

(57) Bei einem Thyristor mit abschaltbaren Emitter-Kurzschlüssen durch monolithisch integrierte Transistorstrukturen wird eine vereinfachte Herstellung und verbesserte Steuerung der Kurzschlüsse dadurch erreicht, dass als Transistorstruktur eine bipolare Struktur in das Bauelement integriert wird. Bei einem bevorzugten Ausführungsbeispiel ist die $n^+$-Emitterschicht (1) des Thyristors durch Zwischenräume unterbrochen, in denen die Transistorstruktur jeweils angeordnet ist.

FIG.1

EP 0 226 021 A1

## Thyristor mit schaltbarem Emitter-Kurzschluss

Die vorliegende Erfindung betrifft einen Thyristor mit schaltbarem Emitter-Kurzschluss gemäss dem Oberbegriff des Anspruchs 1. Ein solcher Thyristor ist z.B. aus der DE-OS 31 18 347 bekannt.

In der Thyristortechnik werden seit langem auf der Kathodenseite des Thyristors lokale, feste Emitter-Kurzschlüsse eingebaut, welche die Blockierfähigkeit des Bauelements auch bei einem sehr schnellen Anstieg ($dU_A/dt$) der Anodenspannung gewährleisten sollen (siehe z.B. Gentry, F.E.; et al. "Semiconductor Controlled Rectifiers", Prentice Hall Inc., 1964, S. 138 f.). Durch die Emitter-Kurzschlüsse können dabei Verschiebungsströme, wie sie bei schnellen Spannungsanstiegen auftreten, ohne Ansteuerung des npn-Teiltransistors des Thyristors abfliessen.

Neben dem Vorteil der verbesserten Blockierfähigkeit haben die festen Emitter-Kurzschlüsse jedoch den Nachteil einer verschlechterten Zündempfindlichkeit und eines erhöhten Haltestroms. Darüber hinaus stellen die Kurzschlüsse ein Hindernis für die Ausbreitung der Zündfront dar, was einer Beschränkung der Stromanstiegsgeschwindigkeit (dI/dt) beim Einschalten gleichkommt.

Zur Vermeidung dieser Nachteile ist nun vorgeschlagen worden (siehe z.B. die DE-OS 31 18 353), die Emitter-Kurzschlüsse entsprechend dem Schaltzustand des Thyristors ein-bzw. auszuschalten, wobei während des Zündvorgangs und im Durchlasszustand des Thyristors die Emitter-Kurzschlüsse unterbrochen bzw. abgeschaltet und während des Blockierzustandes eingeschaltet sind.

Die Schaltbarkeit der Emitter-Kurzschlüsse wird in der genannten Druckschrift dadurch erreicht, dass die an die Oberfläche tretenden Bereich der p-Basisschicht des Thyristors von der Kathode unabhängig kontaktiert und über einen externen Feldeffekttransistor (FET) als Schalter mit der Kathode leitend verbunden werden können.

Gemäss der Lehre aus der eingangs erwähnten Druckschrift (DE-OS 31 18 347) kann der FET-Schalter auch in Form einer MIS-FET-Struktur direkt in die Thyristorstruktur monolithisch integriert werden.

Diesen bekannten Lösungen ist gemeinsam, dass als Schaltelemente für die Emitter-Kurzschlüsse Feldeffekttransistoren eingesetzt werden. Da die treibende Spannung für den im Emitter-Kurzschluss fliessenden Strom prinzipiell kleiner als etwa 0,7 Volt ist, muss bei der Dimensionierung ein möglichst geringer Bahnwiderstand angestrebt werden, um einen genügend hohen Kurzschlussstrom zu erreichen. Dies erfordert geringe laterale Abstände zwischen den einzelnen Kurzschlüssen und kleine Widerstände in den Schalttransistoren im eingeschalteten Zustand.

Da die Feldeffekttransistoren bezüglich ihrer Durchlasscharakteristik jedoch ein näherungsweise ohmsches Verhalten zeigen, d.h. die über dem Schalter abfallende Spannung immer ungefähr proportional zum Strom ansteigt, ist der maximale Kurzschlussstrom durch die Struktur des Schaltelements von Anfang an begrenzt.

Aufgabe der vorliegenden Erfindung ist es nun, einen Thyristor mit abschaltbarem Emitter-Kurzschluss zu schaffen, bei dem der maximale Kurzschlussstrom im Emitter-Kurzschluss deutlich erhöht ist und die Wirksamkeit des Kurzschlusses über einen weiten Bereich gesteuert werden kann.

Die Aufgabe wird bei einem Thyristor der eingangs genannten Art durch die Merkmale aus dem Kennzeichen des Anspruchs 1 gelöst.

Die erfindungsgemässe Ausbildung der von aussen steuerbaren Transistorstruktur als bipolarer Transistor hat gegenüber dem FET den Vorteil, dass die Kollektor-Emitterspannung des bipolaren Transistors im Sättigungsbetrieb mit etwa 0,2 -0,3 Volt nur wenig von dem jeweiligen Kollektorstrom abhängt und damit der Kurzschlussstrom durch entsprechende Wahl des Basisstroms über einen weiten Bereich gesteuert werden kann. Zugleich entfällt die beim FET vorhandene Begrenzung durch das ohmsche Verhalten des FET-Kanals.

Die monolithische Integration eines bipolaren Transistors hat darüber hinaus den weiteren Vorteil, dass das gesamte Bauelement in reiner Bipolar-Technologie hergestellt werden kann, wodurch sich die Herstellung wesentlich vereinfacht.

Die Erfindung soll nun nachfolgend im Zusammenhang mit der Zeichnung anhand von Ausführungsbeispielen näher erläutert werden. Es zeigen

Fig. 1 ausschnittsweise den Querschnitt durch eine Thyristorstruktur mit monolithisch integrierter Transistorstruktur gemäss einem bevorzugten Ausführungsbeispiel der Erfindung;

Fig. 2 ausschnittsweise in Draufsicht die kathodenseitige Flächenstruktur eines Thyristors gemäss Fig. 1 mit hexagonalen Einzelelementen der $n^+$-Emitterschicht;

Fig. 3A den Verlauf der Dotierungskonzentration entlang der Linie A-A in Fig. 1; und

Fig. 3B das entsprechende Dotierungsprofil entlang der Linie B-B in Fig. 1.

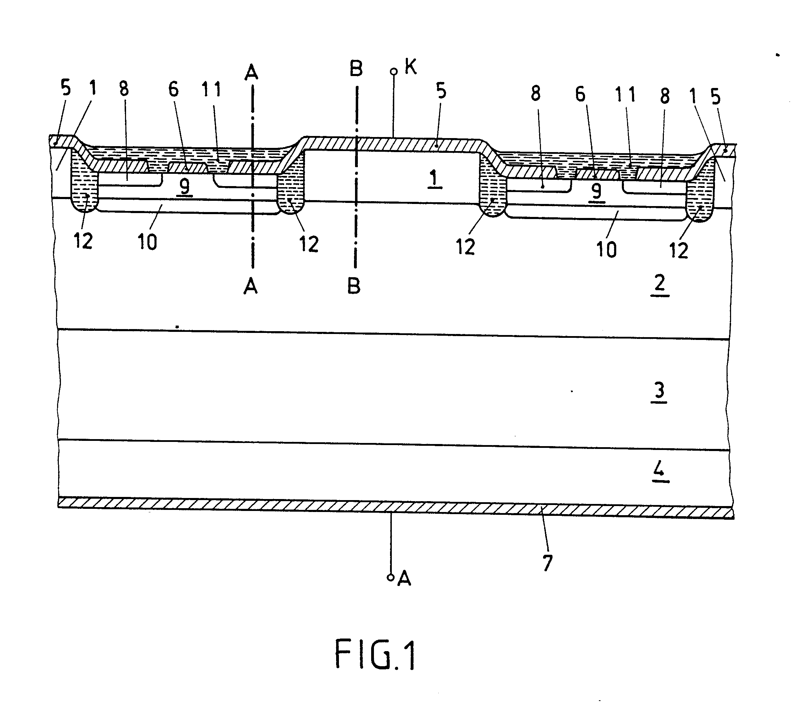

In Fig. 1 ist ausschnittsweise der Querschnitt durch eine Thyristorstruktur mit monolithisch integrierter bipolarer Transistorstruktur gemäss einem bevorzugten Ausführungsbeispiel dargestellt. Die Thyristorstruktur wird durch eine Folge verschieden dotierter Schichten gebildet, welche von unten nach oben eine p-Emitterschicht 4, eine n⁻-Basisschicht 3, eine p-Basisschicht 2 und eine n⁺-Emitterschicht 1 umfasst. Auf der Oberfläche der p-Emitterschicht 4 ist ein metallischer, beispielsweise als Al-Film ausgebildeter Anodenkontakt 7 angebracht und mit der Anode A des Thyristors verbunden. Auf der Oberfläche der n⁺-Emitterschicht 1 ist entsprechend ein Kathodenkontakt 5 vorgesehen, der mit der Kathode K des Thyristors in Verbindung steht. Die bei dem Thyristor grundsätzlich vorhandenen Zündeinrichtungen und die dazugehörige Gatekontaktierung sind beim vorliegenden Thyristor von üblicher Ausgestaltung und daher in der Fig. 1 der Uebersichtlichkeit halber nicht eingezeichnet.

Die bipolare Transistorstruktur, die in Fig. 1 zweimal dargestellt ist, umfasst eine Schichtenfolge aus einem p⁺-dotierten Emitter 10, einer n-dotierten Basis 9 und einem p-dotierten Kollektor 8, welche einen pnp-Transistor bildet.

Die n⁺-Emitterschicht 1 der Thyristorstruktur ist nicht durchgehend ausgebildet, sondern durch Zwischenräume unterbrochen. In diesen Zwischenräumen ist jeweils die beschrie bene Transistorstruktur angeordnet, wobei die verschieden dotierten Halbleiterschichten der Transistorstruktur weitgehend parallel zu den entsprechenden Schichten der Thyristorstruktur verlaufen.

Der Emitter 10 der Transistorstruktur grenzt in dem Zwischenraum mit seiner Unterseite flächig an die p-Basisschicht 2, so dass der Emitter 10 mit dieser Schicht direkt leitend verbunden ist. Der Kollektor 8 ist mit der Kathode K des Thyristors ebenfalls galvanisch verbunden. Dies wird erreicht durch den Kathodenkontakt 5, der über die Fläche der n⁻-Emitterschicht 1 seitlich soweit hinausragt, dass er den Kollektor 8 der benachbarten Transistorstruktur teilweise überlappt und berührt.

Die Basis 9 der Transistorstruktur ist im mittleren Bereich der Struktur durch die Ebene des Kollektors 8 an die Oberfläche geführt und dort mit einem Basiskontakt 6 versehen, der die Transistorstruktur von aussen ansteuerbar werden lässt. Insgesamt ist die kombinierte Thyristor-Transistor-Struktur im Querschnitt zumindest in den Bereichen, wo die Emitter-Kurzschlüsse vorgesehen sind, periodisch mit abwechselnd einer Transistorstruktur und einer n⁺-Emitterschicht 1.

Zwischen den Teilstrukturen werden zur elektrischen Trennung von Thyristor und Transistor vorzugsweise tiefe Gräben 12 angeordnet, die beispielsweise durch einen anisotropen Aetzvorgang erzeugt werden können. Die Gräben 12 sind vorteilhafterweise mit einem Isoliermaterial, speziell Polyimid, aufgefüllt und durch den überlappenden Kathodenkontakt abgedeckt. Die Tiefe der Gräben 12 ist dabei so gewählt, dass sie mindestens bis zur p-Basisschicht 2 reichen.

Die Transistorstruktur einschliesslich des Basiskontakts 6 und der überlappenden Bereiche des Kathodenkontakts 5 kann ebenfalls zu Zwecken der Passivierung mit einer Abdeckschicht 11 aus Polyimid bedeckt werden. Der über der n⁺-Emitterschicht 1 liegende Teil des Kathodenkontakts 5 bleibt jedoch frei für den Kontakt mit dem nicht eingezeichneten kathodenseitigen Druckkontakt.

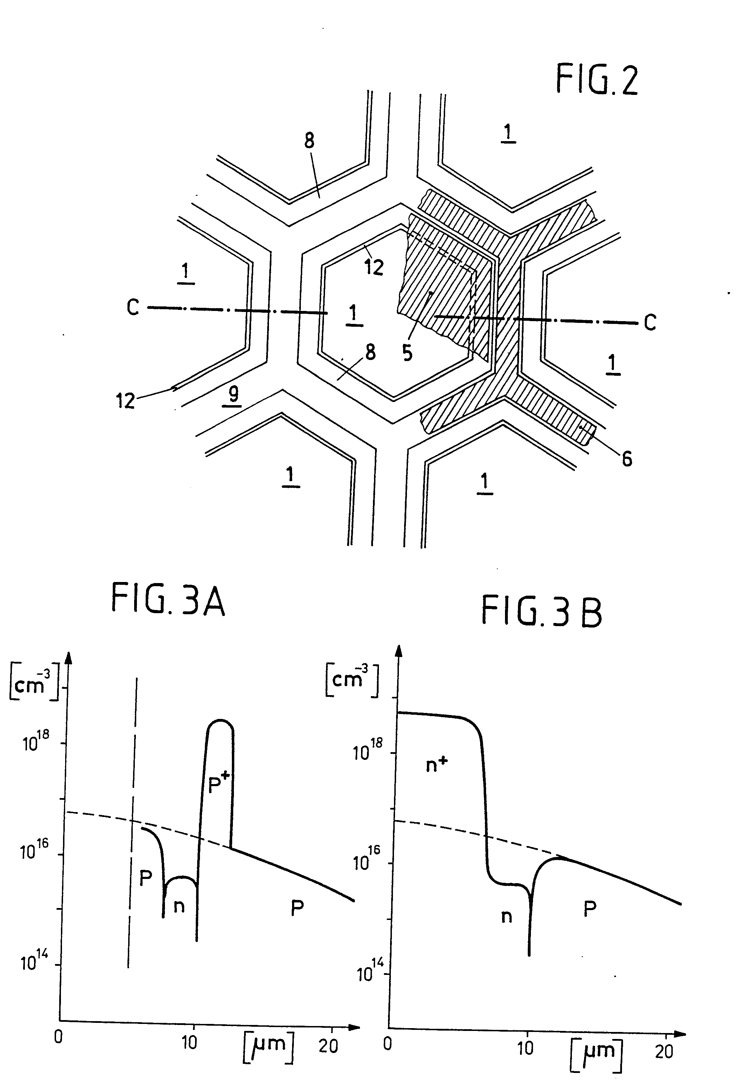

Während Fig. 1 die kombinierte Struktur im Querschnitt zeigt, ist in der Fig. 2 dargestellt, wie in einem bevorzugten Ausführungsbeispiel die Anordnung der Strukturen in der Fläche, gesehen von der Kathodenseite aus, vorgenommen wird, um eine möglichst gleichförmige Stromverteilung und damit Belastung des Bauelements zu erreichen.

Die Flächenstruktur setzt sich zusammen aus einer Vielzahl von regelmässig angeordneten hexagonalen Einzelelementen der n⁺-Emitterschicht 1, die nicht direkt aneinanderstossen, sondern jeweils allseitig von einem Zwischenraum umgeben sind, der die Transistorstruktur aufnimmt. Da die Kathodenkontakte 5 und der Basiskontakt 6 nur ausschnittsweise als schraffierte Flächen eingezeichnet sind, lassen sich bei der Transistorstruktur die wabenförmige, an die Oberfläche der Struktur stossende Basis 9, sowie die verschiedenen Teilbereiche des Kollektors 8 erkennen. Desgleichen sind auch die Gräben 12, die jedes hexagonale Einzelelement der n⁺-Emitterschicht 1 umgeben, zu sehen. Ein Querschnitt entlang der dargestellten Linie C-C entspricht dem Bild aus Fig. 1.

Die wabenförmig ausgebreitete Transistorstruktur bildet einen einzigen, über die Fläche verteilten Kurzschlussschalter, der mit einem Strom auf die Basis 9 die Kathode K mit der p-Basisschicht 2 kurzschliesst. Besonders günstig auf das Betriebsverhalten des Thyristors wirken sich die geschalteten Emitter-Kurzschlüsse aus, wenn die lateralen Abstände zwischen den hexagonalen Einzelelementen im Bereich von etwa 200 μm bis 1000 μm liegen, was einer Halbierung der bei ungeschalteten Kurzschlüssen verwendeten Abstände entspricht.

Darüber hinaus kann der Thyristor mit Hilfe der in Fig. 1 und 2 dargestellten Struktur auch aktiv abgeschaltet werden. Hierzu müssen die genannten lateralen Abstände jedoch kleiner als 50 μm sein.

Die vorzugsweise verwendeten Dotierungsprofile für die Transistor-und Thyristorstruktur, wie sie sich entlang der in Fig. 1 eingezeichneten Linien A-A bzw. B-B ergeben, sind in den Fig. 3A bzw. 3B wiedergegeben. Die in cm$^{-3}$ angegebene Dotierungskonzentration ist dabei über der in μm angegebenen Tiefe, gemessen von der kathodenseitigen Oberfläche der n$^+$-Emitterschicht 1 aus, aufgetragen.

In Fig. 3A beginnt das Dotierungsprofil der tiefer gelegenen Transistorstruktur erst in etwa 5 μm Tiefe mit der p-Dotierung des Kollektors 8, gefolgt von einer geringeren n-Dotierung der Basis 9 und der starken p$^+$-Dotierung des Emitters 10, welche übergeht in die zugrundeliegende p-Dotierung der p-Basisschicht 2 des Thyristors.

Das Dotierungsprofil des Thyristors in Fig. 3B beginnt mit einer hohen n$^+$-Dotierung der n$^+$-Emitterschicht 1, gefolgt von einer Zwischenschicht mit geringer n-Dotierung, die in Fig. 1 nicht berücksichtigt ist, und von der zugrundeliegenden p-Dotierung der p-Basisschicht 2 des Thyristors.

Die n-dotierte Zwischenschicht im Thyristor ergibt sich, wenn gemäss einem bevorzugten Ausführungsbeispiel die n$^+$-Emitterschicht 1 eine durch epitaktisches Aufwachsen auf die p-Basisschicht 2 erzeugte Schicht ist.

Weiterhin ist auch von Vorteil, wenn der Emitter 10 durch Implantation in die p-Basisschicht 2 hergestellt wird.

Wie bereits erwähnt, liegt die Oberfläche der Transistorstruktur etwa 5 μm tiefer als die der Thyristorstruktur.

Dadurch werden für den Kathodenkontakt 5 und den Basiskontakt 6 unterschiedliche Ebenen geschaffen, welche den Anschluss des Bauelements wesentlich erleichtern.

Insgesamt wird durch die Erfindung ein Thyristor mit schaltbaren Emitter-Kurzschlüssen bereitgestellt, der nicht nur vollständig in nur einer Technologie und damit einfacher hergestellt werden kann, sondern vor allem auch durch eine verbesserte Steuerung der Kurzschlüsse ausgezeichnet ist.

## BEZEICHNUNGSLISTE

1 n$^+$-Emitterschicht
2 p-Basisschicht
3 n$^-$-Basisschicht
4 p-Emitterschicht
5 Kathodenkontakt
6 Basiskontakt
7 Anodenkontakt
8 Kollektor
9 Basis
10 Emitter
11 Abdeckschicht
12 Graben
n, n$^+$, p, p$^+$ Dotierungskonzentration
A Anode
K Kathode

## Ansprüche

1. Thyristor mit schaltbarem Emitter-Kurzschluss, mit einer Schichtenfolge aus einer p-Emitterschicht, einer n$^-$-Basisschicht, einer p-Basisschicht und einer n$^+$-Emitterschicht sowie Mitteln zum Kurzschliessen der n$^+$-Emitterschicht, welche Mittel eine monolithisch in den Thyristor integrierte und von aussen steuerbare Transistorstruktur umfassen, dadurch gekennzeichnet, dass die Transistorstruktur als bipolarer Transistor ausgebildet ist.

2. Thyristor nach Anspruch 1, dadurch gekennzeichnet, dass

a) die Transistorstruktur eine Schichtenfolge von drei im wesentlichen übereinander angeordneten Schichten umfasst, von denen die untere p$^+$-dotiert ist und einen Emitter (10), die mittlere n-dotiert ist und eine Basis (9), und die obere p-dotiert ist und einen Kollektor (8) der Transistorstruktur bilden;

b) der Kollektor (8) mit der Kathode (K) des Thyristors galvanisch verbunden ist;

c) die Basis (9) über einen Basiskontakt (6) von aussen ansteuerbar ist; und

d) der Emitter (10) mit der p-Basisschicht (2) galvanisch verbunden ist.

3. Thyristor nach Anspruch 2, dadurch gekennzeichnet, dass

a) die n$^+$-Emitterschicht (1) des Thyristors durch Zwischenräume unterbrochen ist, in welchen Zwischenräumen die Transistorstruktur jeweils angeordnet ist; und
der Emitter (10) der Transistorstruktur mit seiner Unterseite flächig an die p-Basisschicht (2) angrenzt.

4. Thyristor nach Anspruch 3, dadurch gekennzeichnet, dass

a) die n$^+$-Emitterschicht (1) in der Fläche als eine regelmässige Anordnung einer Vielzahl von hexagonalen Einzelelementen ausgebildet ist; und

b) jedes hexagonale Einzelelement von der Transistorstruktur umgeben und von den anderen Elementen getrennt ist.

5. Thyristor nach Anspruch 4, dadurch gekennzeichnet, dass

a) die Transistorstruktur von dem n$^+$-Emitter (1) jeweils durch bis zur p-Basisschicht (2) reichende Gräben (12) elektrisch getrennt ist; und

b) die Gräben (12) mit Isoliermaterial, vorzugsweise Polyimid, gefüllt sind.

6. Thyristor nach Anspruch 5, dadurch gekennzeichnet, dass die galvanische Verbindung zwischen der Kathode (K) und dem Kollektor (8) der Transistorstruktur durch einen Kathodenkontakt (5) in Form einer Metallisierungsschicht hergestellt ist, welche die n⁺-Emitterschicht (1) überdeckt und über die Fläche jedes hexagonalen Einzelelements soweit hinausragt, dass sie den Kollektor (8) der benachbarten Transistorstruktur teilweise überlappt und berührt.

7. Thyristor nach Anspruch 4, dadurch gekennzeichnet, dass die lateralen Abstände der hexagonalen Einzelelemente zwischen 200 μm und 1000 μm betragen.

8. Thyristor nach Anspruch 4, dadurch gekennzeichnet, dass die lateralen Abstände der hexagonalen Einzelelemente kleiner als 50 μm sind.

9. Thyristor nach Anspruch 3, dadurch gekennzeichnet, dass

    a) die Basis (9) der Transistorstruktur im mittleren Bereich durch die Ebene des Kollektors - (8) an die Oberfläche der Transistorstruktur geführt und dort mit dem Basiskontakt (6) versehen ist; und

    b) der Basiskontakt (6) in einer anderen Ebene liegt, als der Kathodenkontakt (5).

10. Thyristor nach Anspruch 3, dadurch gekennzeichnet, dass

    a) der Emitter (10) eine durch Implantation in der p-Basisschicht erzeugte Schicht ist; und

    b) die n⁺-Emitterschicht (1) eine durch epitaktisches Aufwachsen erzeugte Schicht ist.

FIG.1

FIG.2

FIG.3A

FIG.3B

114/85

Europäisches
Patentamt

# EUROPÄISCHER RECHERCHENBERICHT

Nummer der Anmeldung

EP 86 11 5303

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| X | GB-A-2 130 028 (B.W. WILLIAMS) * Zusammenfassung; Figur 5 * | 1-3 | H 01 L 29/743 H 01 L 29/08 |
| | --- | | |
| A | INTERNATIONAL ELECTRON DEVICES MEETING, Washington, D.C., 8.-10. Dezember 1980, Seiten 91-94, IEEE, New York, US; J. MENA et al.: "High frequency performance of VDMOS power transistors" * Figur 5 * | 4 | |
| | ----- | | |

| | RECHERCHIERTE SACHGEBIETE (Int. Cl.4) |
|---|---|
| | H 01 L 29 |

Der vorliegende Recherchenbericht wurde für alle Patentansprüche erstellt.

| Recherchenort | Abschlußdatum der Recherche | Prüfer |
|---|---|---|
| DEN HAAG | 20-02-1987 | PELSERS L. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82